Europäisches Patentamt

European Patent Office

Office européen des brevets

(11) Veröffentlichungsnummer: **0 394 861**
**A2**

(12) **EUROPÄISCHE PATENTANMELDUNG**

(21) Anmeldenummer: **90107506.9**

(51) Int. Cl.5: **H03K 5/01**

(22) Anmeldetag: **20.04.90**

(30) Priorität: **24.04.89 DE 3913395**

(43) Veröffentlichungstag der Anmeldung:
**31.10.90 Patentblatt 90/44**

(84) Benannte Vertragsstaaten:
**AT DE FR GB IT**

(71) Anmelder: **GRUNDIG E.M.V.**
**Elektro-Mechanische Versuchsanstalt Max**
**Grundig holländ. Stiftung & Co. KG.**
**Kurgartenstrasse 37**
**D-8510 Fürth/Bay.(DE)**

(72) Erfinder: **Mahmud, Shabaz, Grundig E.M.V.**
**Max Grundig, holländ. Stiftung & Co KG.**
**Kurgartenstrasse 37, D-8510 Fürth/Bay(DE)**

(54) **Digitale Filterlogik.**

(57)

1. Bei der Verarbeitung von digitalen Signalen müssen kurzzeitige Störimpulse, die dem Eingangssignal überlagert sind, herausgefiltert werden, um die Funktionsfähigkeit der digitalen Signalvearbeitungseinheit nicht zu beeinträchtigen. Aufgabe der Erfindung ist es deshalb eine Filterlogik aufzubauen, welche kurzzeitige Störimpulse unterdrückt, wobei die Zeitdauer der unterdrückbaren Störimpulse veränderbar ist.

2.2. Dies wird dadurch erreicht, daß das Eingangssignal zunächst zu einem vorgegebenen Takt synchronisiert wird und anschließend n-mal um eine Taktperiode verzögert wird, wobei Störimpulse mit n-facher Taktperiodendauer ausgefiltert werden. Das n-fach verzögerte Signal und das zum Takt synchronisierte Eingangssignal gehen an ein Exclusiv-Gatter, dessen Ausgang an den Steuereingang eines Multiplex-D-FF geht und der Ausgang dieses Flip-Flops das gefilterte Signal ist. Das Exclusiv-ODER-Gatter steuert dabei das Multiplex-D-FF so, daß bei unterschiedlichen Eingangspegeln am Exclusiv-ODER, d.h. wenn z.B. ein Störimpuls vorliegt, das bestehende Ausgangssignal erhalten und bei gleichem Eingangspegel, d.h. wenn das ungestörte Signal anliegt, dieses an den Augang durchgeschaltet wird.

2.3. Geräte mit digitaler Signalverarbeitung

EP 0 394 861 A2

Figur 1

Die Erfindung bezieht sich auf eine digitale Filterlogik, die es erlaubt kurzzeitige Störungen in einem binären Signal zu unterdrücken.

Bei der Verarbeitung von digitalen Signalen ist es notwendig Störimpulse im zu verarbeitenden Eingangssignal zu unterdrücken, um die Funktionsfähigkeit der Anordnung zu gewährleisten.

In der DE-OS 36 02 801 wird eine Digitalfilterschaltung zur Ausfilterung der Störimpulse beschrieben. Diese Anordnung setzt sich aus Zählern zusammen, die bei bestimmten Zählerständen einen Verriegelungskreis setzen oder rücksetzten. Das Eingangssignal muß für eine vorbestimmte Anzahl von Taktimpulsen auf einem logischen Pegel sein, um diesen dann an den Ausgang zu übernehmen. Der Nachteil dieser Anordnung besteht darin, daß Störimpulse, die in ungünstigen Momenten, d.h. bei Übernahme des Eingangspegels auftreten oder Störimpulse, die länger als eine Taktperiode sind, das Signal am Filterausgang verfälschen.

Der Erfindung liegt deshalb die Aufgabe zugrunde, eine digitale Filterlogik anzugeben, mit der auch Störimpulse unterdrückt werden können, die länger als eine Taktperiode sind. Weiterhin soll die maximale Dauer der unterdrückbaren Störimpulse vorgebbar sein, wobei die maximal unterdrückbare Störimpulsdauer kleiner ist als die minimale Dauer eines Signalpegels des zu entstörenden Eingangssignals.

Diese Aufgabe wird durch den kennzeichnenden Teil des Anspruchs 1 gelöst.

Zunächst wird das zu entstörende, binäre Signal mit dem Taktsignal synchronisiert, indem es in einem Verzögerungsglied bis zum Beginn der nächsten Taktperiode verzögert wird. Anschließend wird dieses Signal in n Verzögerungsstufen um n Taktperioden verzögert. Das mit dem Takt synchronisierte Signal und das n-fach verzögerte Signal werden einer Vergleichsschaltung zugeführt. Diese Vergleichsschaltung steuert eine Auswahllogik an, an der das auf den Takt synchronisierte Signal anliegt und außerdem das momentan gültige Ausgangssignal, d.h. der Ausgang der Filterlogik ist auf einen von zwei Eingängen der Auswahllogik rückgeführt.

Wenn in der Vergleichsschaltung Gleichheit der Signale festgestellt wird, wird das auf den Takt synchronisierte Signal an den Ausgang gegeben. Bei Ungleichheit wird eine Störung angenommen und das zuletzt gültige Ausgangssignal wird als neues Ausgangssignal übernommen. Auf diese Weise wird eine kurze Störung unterdrückt.

Bei einem Wechsel des Signalpegels wird der neue Signalpegel erst nach n Taktperioden an den Ausgang übernommen, da erst nach dieser Zeit das synchronisierte Signal mit dem n-fach verzögerten Signal gleich ist. Daraus ergibt sich die Forderung, daß ein Signalpegel des zu entstörenden Signals mindestens $n+1$ Taktperioden anliegen muß, d.h. es werden Störimpulse erkannt, deren Dauer kürzer ist als die minimale Dauer eines Signalpegels.

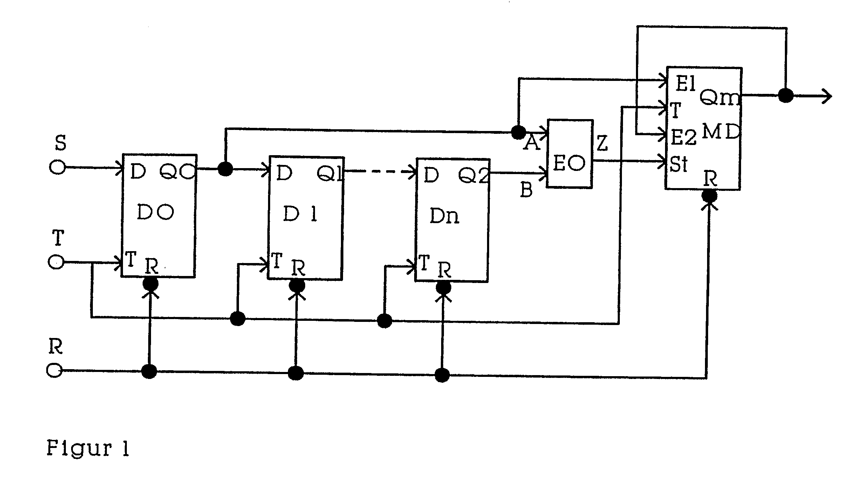

Eine digitale Filterlogik nach der Erfindung ist in Fig. 1 dargestellt.

Das Eingangssignal S wird auf den D-Eingang eines ersten D-Flip-Flop D0 geführt. Der Ausgang Q0 dieses D-Flip-Flops ist verbunden mit dem D-Eingang eines zweiten D-Flip-Flops D1, mit dem Eingang A eines Exclusiv-ODER-Gatters und mit dem D-Eingang E1 eines Multiplex-D-Flip-Flop MD. Das Signals am Ausgang Q1 wird an den Eingang D des D-Flip-Flop D2 geführt, usw.. Auf diese Weise sind insgesamt n D-Flip-Flops verbunden. Der Ausgang Qn des n-ten führt zum zweiten Eingang B des Exclusiv-ODER-Gatters. Der Ausgang Z dieses Gatters ist mit dem Steuereingang St des Multiplex-D-Flip-Flop MD verbunden. Der Ausgang Qm dieses Flip-Flops MD bildet das störbefreite Signal. Dieser Ausgang wird auch noch auf den zweiten Eingang E2 zurückgeführt.

Außerdem werden alle Eingänge T der Flip-Flops D0-Dn und des Multiplex-D-Flip-Flop mit dem gleichen Taktsignal versorgt. Weiterhin werden alle Reset-Eingänge R der obengenannten Flip-Flops mit dem gleichen Reset-Signal verbunden.

Das erste D-Flip-Flop D0 dient der Synchronisierung des zu filternden Eingangssignals auf das Taktsignal. Das Ausgangssignal an Q0 ist somit auf den nächsten Taktanfang verschoben. Weitere n D-Flip-Flops verzögern das Eingangssignal noch n-mal. Die Zahl der Verzögerungen ist abhängig von der Dauer der zu beseitigenden Störimpulse. Die untere Grenze zum sicheren Entstören ist eine Verzögerung, d.h. $n = 1$, die obere Grenze ist abhängig von der maximalen Frequenz des Eingangssignals, d.h. die maximale erkennbare Störimpulsdauer muß kleiner sein als die kleinstmögliche Periode des zu entstörenden Eingangssignals.

Der Ausgang Qn des n-ten D-Flip-Flop geht an einen Eingang B eines Exclusiv-ODER-Gatters, dessen anderer Eingang A mit dem auf den Takt synchronisierten Eingangssignal verbunden ist. Der Ausgang des Exclusiv-ODER-Gatters E0 führt zum Steuereingang eines Multiplex-D-Flip-Flops. Hier wird an den Ausgang entweder das Signal an E1, d.h. das synchronisierte Eingangssignal übernommen, wenn am Steuereingang St eine logische Null anliegt oder das Signal an E2, d.h. das gefilterte Eingangssignal, wenn am Steuereingang St eine logische Eins anliegt. Die Wahrheitstabelle zum Multiplex-D-Flip-Flop zeigt Tabelle 1.

| T | E1 | E2 | ST | Q |
|---|---|---|---|---|
| ↑ | 0 | X | 0 | 0 |
| ↑ | 1 | X | 0 | 1 |
| ↑ | X | 0 | 1 | 0 |
| ↑ | X | 1 | 1 | 1 |

Tabelle 1

Das Multiplex-D-Flip-Flop ist aktiv, wenn an R eine logische Eins anliegt und die Datenübernahme erfolgt bei ansteigender Flanke des Taktsignals. Am Steuereingang St liegt eine logische Eins, wenn die beiden Eingänge des Exclusiv-ODER E0 unterschiedlichen Pegel haben, d. h. wenn das synchronisierte Eingangssignal und das n-fachverzögerte verschiedene Pegel haben. Dies ist der Fall, wenn Störimpulse auftreten oder bei Pegelwechsel des Eingangssignals, wenn dieser nicht länger als n-Taktperioden zurückliegt. Hier wird das Signal am Eingang E2, also das Ausgangssignal Qm durchgeschaltet. Das bedeutet, daß am Ausgang keine Veränderung eintritt. Wenn am Eingang ein Störimpuls vorliegt, wird dieser also nicht an den Filterausgang übertragen. Bei Vorliegen eines Pegelwechsels des Eingangssignals wird dieser erst nach n + 1 Taktperioden durchgeschaltet, wobei die Verzögerung durch das erste D-Flip-Flop D0 zur Synchronisierung mit dem Taktsignal nicht mitgezählt ist.

Wenn am Ausgang des Exclusiv-ODER-Gatters E0 eine logische Null anliegt, d.h. wenn Q0 und Qn gleichen Pegel haben, und somit kein Störsignal vorliegt, wird am Multiplex-D-Flip-Flop das synchronisierte Eingangssignal Q0 an den Ausgang Qm übergeben.

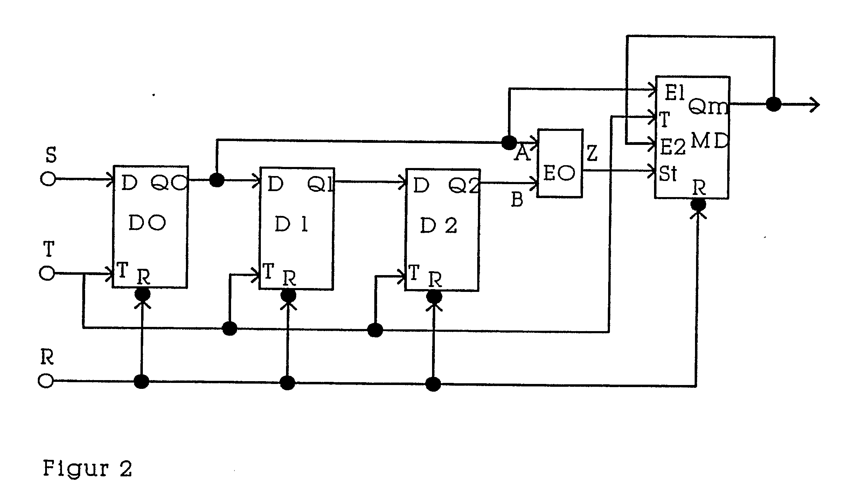

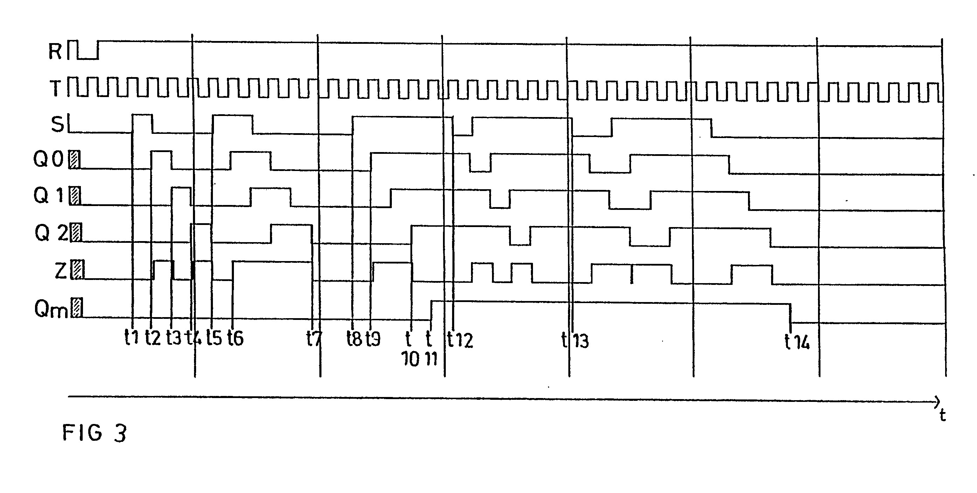

Fig. 2 zeigt eine Ausführung der Erfindung mit n = 2, d.h. Störimpulse, die höchstens zwei Taktperioden lang sind, werden ausgefiltert. Fig. 4 zeigt das zugehörige Zeitdiagramm. Der Aufbau der Logikschaltung in Fig. 3 entspricht dem in Fig. 1, wobei n auf n = 2 beschränkt ist und somit die Zahl der D-Flip-Flops auf drei reduziert ist. Das zugehörige Zeitdiagramm zeigt Bild 3. Hier wird zunächst das Reset-Signal R dargestellt, das nach einem Rücksetz-Impuls - zur Initialisierung der Anordnung - von der Dauer einer Taktperiode auf den logischen Pegel eins geht. Anschließend ist das Taktsignal T dargestellt und darunter das Eingangssignal S. Die drei folgenden Zeilen zeigen die Ausgangssignale Q0 bis Q2 der drei D-Flip-Flops. Danach wird das Signal im Ausgang Z dargestellt, welches das Steuersignal für das Multiplex-D-Flip-Flop ist. Schließlich wird das gefilterte Signal Qm dargestellt.

Das Eingangssignal hat zunächst den logischen Pegel Null. Zum Zeitpunkt $t_1$ tritt ein Störim-puls auf, der zum Zeitpunkt $t_2$ an Q0 übernommen wird, anschließend in Q1 und zum Zeitpunkt $t_4$ in Q2. Das Signal Z ist nach dem Rücksetzen zunächst auf dem logischen Pegel Null. Zum Zeit-punkt $t_2$, wenn Q0 den Pegel Eins hat und Q2 noch Null, geht der Pegel des Exclusiv-ODER-Ausgangs Z auf 1, so daß in den Ausgang Qm des Multiplex-D-FF MD der letzte Pegel Qm wieder übernommen wird. Zum Zeitpunkt $t_3$ geht der logische Pegel von Z wieder auf Null, da Q0 und Q2, an den Eingängen von E0 den gleichen Pegel haben. Zum Zeit-punkt $t_4$ wird Z wieder Eins, da an Q2 der verzögerte Störimpuls zum Tragen kommt, während an Q0 der ungestörte Null-Pegel des Eingangssignals liegt, und damit die beiden Eingänge von E0 verschiedene Pegel haben. Zum Zeitpunkt $t_5$ liegt ein zweiter Störimpuls, der die Dauer von zwei Taktperioden hat und somit noch unterdrückt wird. Zum Zeitpunkt $t_6$ geht der Pegel von Q0 auf Eins, während der von Q2 noch auf Null liegt, d.h. am Ausgang Z des Exclusiv-ODER-Gatters E0 wird der Pegel ebenfalls Eins. Dieser bleibt solange auf Eins, wie Q0 und Q2, d.h. Eingänge A und B des Exclusiv-ODER- Gatters verschiedene Pegel haben, was solange der Fall ist, bis das verzögerte Störsignal am Q2 zum Zeitpunkt $t_7$ verschwindet. In der Zeit zwischen $t_6$ und $t_7$ bleibt also das bestehende Ausgangssignal Qm erhalten, danach wird wieder das Signal Q0 durchgeschaltet. Zum Zeitpunkt $t_8$ ändert sich der Eingangspegel auf die logische Eins und wird zum Zeitpunkt $t_9$ an Q0 übenommen, während Q2 noch den vorherigen Pegel (Null) hält. Somit geht das Signal Z auf logisch Eins und der Pegel Null von vorher bleibt am Ausgang des Filters Qm bestehen. Zum Zeitpunkt $t_{10}$ liegt auch an Q2 der Eingangspegel Eins, wie an Q0 und folglich fällt an Z der Pegel auf Null, was zur Folge hat, daß beim Beginn der nächsten Taktperiode zum Zeitpunkt $t_{10}$ Q0 durchgeschaltet wird, d.h. Qm den logischen Pegel Eins annimmt.

Zu den Zeitpunkten $t_{12}$ und $t_{13}$ liegen wieder Störimpulse vor, die denen zu den Zeitpunkten $t_1$ und $t_5$ entsprechen, wobei die Pegel invertiert sind. Der logische Ablauf entspricht dem vorherigen und wird deshalb nicht nochmals beschrieben.

**Ansprüche**

1. Digitale Filterlogik zur Beseitigung von Störimpulsen in einem binären Signal, die eine Dauer von höchstens n Taktperioden haben, **dadurch gekennzeichnet, daß**
- das binäre Signal in einem ersten Verzögerungsglied bis zum Beginn der nächsten Taktperiode verzögert wird,
- dieses Signal in n weiteren Verzögerungsgliedern um n Taktperioden verzögert wird,
- das im ersten und das im n-ten Verzögerungsglied verzögerte binäre Signal einer Vergleichsschaltung zugeführt werden,
- in einer Auswahllogik in Abhängigkeit vom Vergleichsergebnis der Vergleichsschaltung das Signal am Ausgang des ersten Verzögerungsglieds - bei Gleichheit - oder das zuletzt gültige Ausgangssignal - bei Ungleichheit - als neues Ausgangssignal der Filterlogik ausgewählt wird.

2. Digitale Filterlogik nach Anspruch 1, **dadurchgekennzeichnet, daß**
- das Eingangssignal (S) in einem ersten D-Flip-Flop (D0) bis zum Beginn der nächsten Taktperiode verzögert wird
- das Signal am Ausgang (Q0) dieses D-Flip-Flops (D0) zum Eingang (A) eines Exclusiv-ODER-Gatters (E0) geführt wird
- das Signal am Ausgang (Q0) in n-weiteren D-Flip-Flops (D1-Dn) nochmals um n-Taktperioden verzögert wird
- der Ausgang (Qn) des n-ten D-Flip-Flop (Dn) an den Eingang B des Exclusiv-ODER-Gatters (E0) gelegt ist
- der Ausgang (Z) des Exclusiv-ODER-Gatters (E0) an den Steuereingang (St) eines Multiplex-D-Flip-Flops (MD) mit zwei Dateneingängen (E1 und E2) gelegt ist, wobei der logische Pegel an diesem Steuereingang (St) festlegt, welcher der beiden Dateneingänge (E1 oder E2) durchgeschaltet wird
- am Eingang (E1) des Multiplex-D-Flip-Flops (MD) das Signal des Ausgangs (Q0) und am Eingang (E2) das Signal (Qm) anliegt.
- die Takt-Eingänge (T) aller Flip-Flops mit dem gleichen Taktsignal und die Reset-Eingänge (R) mit dem gleichen Reset-Signal belegt.

3. Digitale Filterschaltung nach Anspruch 2, **dadurch gekennzeichnet, daß die** Dauer der ausfilterbaren Störimpulse durch die Periodendauer des Taktsignals und durch die Anzahl n der Verzögerungen durch die D-Flip-Flops (D1 bis Dn) festgelegt ist.

4. Digitale Filterschaltung nach Anspruch 3, **dadurch gekennzeichnet, daß die** Anordnung so ausgelegt ist, daß die Dauer der erkennbaren Störimpulse kleiner ist als die minimale Periodendauer des zu entstörenden Eingangssignals.

5. Digitale Filterschaltung nach Anspruch 4, **dadurch gekennzeichnet, daß** die Periode des Taktsignals kleiner oder gleich der zu erwartenden minimalen Dauer der Störimpulse ist.

Figur 1

Figur 2

EP 0 394 861 A2

FIG 3